# EUROPÄISCHE PATENTSCHRIFT

(11) **EP 1 166 888 B1**
(45) Veröffentlichungstag und Bekanntmachung des Hinweises auf die Patenterteilung: **20.06.2007**
(21) Anmeldenummer: 01111984.9
(22) Anmeldetag: 22.05.2001
(51) Int. Cl.: B05C 1/08, B05C 11/04

(54) **Auftragsvorrichtung zum Aufbringen von Flüssigkeiten auf plattenförmige Werkstücke**
Coating device for applying a liquid on panel-shaped work pieces
Dispositif d'enduction pour appliquer un produit liquide sur des objets sous forme de plaque

(30) Priorität: 27.06.2000 DE 10030316
(43) Veröffentlichungstag der Anmeldung: 02.01.2002
(73) Patentinhaber: Robert Bürkle GmbH, 72250 Freudenstadt (DE)
(72) Erfinder: Mai, Josef, 72160 Horb-Rexingen (DE)
(74) Vertreter: Kaiser, Magnus

(56) Entgegenhaltungen:
- EP-A- 0 906 788
- DE-A- 19 904 112
- US-A- 4 738 877

## Beschreibung

Die Erfindung betrifft eine Auftragsvorrichtung zum Aufbringen von Flüssigkeiten, insbesondere von Lack, auf plattenförmige Werkstücke nach dem Oberbegriff des beigefügten Patentanspruchs 1.

Auftragsvorrichtungen dieser Art werden beispielsweise zum Beschichten von Leiterplatten mit Fotoresistlack verwendet. Die Aufbringung dieses Lacks auf solche Leiterplatten muss mit hoher Genauigkeit erfolgen, da der Lack sehr dünn und gleichmäßig, typischerweise nur etwa 8 bis 14 Mikrometer dick, aufgetragen werden soll.

Die internationale Anmeldung PCT-DE 97/01414 der Anmelderin zeigt eine Auftragsvorrichtung der eingangs genannten Art, bei der eine Auftragswalze und eine an die Mantelfläche der Auftragswalze anstellbare Rakel zum Aufbringen von Lack auf plattenförmige Werkstücke vorgesehen ist. Zwischen der Rakel und der Auftragswalze wird ein Spalt gebildet, aus dem die Auftragsvorrichtung den Lack entnimmt und zu den plattenförmigen Werkstücken transportiert. Die Gleichmäßigkeit und die Schichtdicke des Lackauftrags hängen entscheidend von der Parallelität und der Breite des Spalts zwischen der Auftragswalze und der Rakel ab. Dies ist in dieser Schrift allerdings nicht problematisiert.

Die EP 0 427 045 A1 der Anmelderin beschäftigt sich hingegen mit dieser Problematik, wobei hier eine Auftragswalze und eine Dosierwalze zur Bildung eines Spalts für den Lackauftrag zusammenwirken. Die Dosierwalze wird zur Reduzierung von Reibungseffekten zwischen der Dosierwalze und der Auftragswalze an zwei stirnseitig angeordneten Pendelgliedern mit Pneumatik- oder Hydraulikzylindern aufgehängt. Die Dosierung des Lacks mit einer Dosierwalze kann allerdings wegen der Schlupfneigung zwischen den beiden Walzen nachteilig sein. Darüber hinaus muss die aus der EP 0 427 045 A1 bekannte Aufhängung der Dosierwalze bei der Anstellbewegung äußerst genau synchronisiert werden, um eine ausreichend genaue Parallelität der Dosierwalze und der Auftragswalze, und somit eine gleichmäßige Spaltbreite über die gesamte Walzenlänge sicherzustellen.

In der EP-A-0 906 788 ist eine gattungsbildende Rakeleinrichtung zur Verwendung in einer Auftragsvorrichtung zum Aufbringen von Flüssigkeiten auf eine Walze beschrieben. Ein Rakelstab ist federnd beweglich in einem fest angeordneten Rakelbalken gelagert, so dass er mindestens zwei Freiheitsgrade besitzt. Die Anstellbewegung des Rakelstabs wird durch zwei separat regelbare, in orthogonalen Richtungen wirkende Federelemente erzeugt, so dass letztendlich die Richtung der Anstellkraft variiert bzw. geregelt werden kann. Eine Verdrehsicherung für den Rakelstab muss aufgrund der Freiheitsgrade federnd ausgebildet sein, so dass ein hoher Regelaufwand zur Gewährleistung einer ausreichenden Parallelität von Rakelstab und Auftragswalze erforderlich ist.

Die US-A- 4 738 877 zeigt eine Auftragsvorrichtung zum Aufbringen von Flüssigkeiten auf eine Papierbahn, wobei eine Dosierrolle zur Ausbildung eines Dosierspalts auf der Mantelfläche der Auftragswalze verwendet wird. Zusätzlich werden Rakel zum Abrakeln überflüssiger Flüssigkeit von der Auftragswalze verwendet.

Ausgehend von diesem Stand der Technik liegt der Erfindung die Aufgabe zugrunde, eine Auftragsvorrichtung zum Aufbringen von Flüssigkeiten auf plattenförmige Werkstücke mit einer auf den plattenförmigen Werkstücken abrollenden Auftragswalze und einer zur Ausbildung eines Spalts an die Mantelfläche der Auftragswalze anstellbaren Rakel, bei der die Flüssigkeit auf der Mantelfläche der Auftragswalze vom Spalt zum plattenförmigen Werkstück transportierbar ist, hinsichtlich der präzisen Einstellung des Spalts zu verbessern.

Gelöst ist diese Aufgabe durch eine Auftragsvorrichtung mit den Merkmalen des beigefügten Patentanspruchs 1.

Bevorzugte Ausführungen und Weiterbildungen der Erfindung ergeben sich aus den Patentansprüchen 2 bis 7.

Die zur Ausbildung eines Spalts für die aufzutragende Flüssigkeit an die Auftragswalze anzustellende Rakel wird erfindungsgemäß also exzentrisch schwenkbar befestigt. Hierdurch kann die Rakel durch eine einfache Schwenkbewegung an die Auftragswalze angestellt oder von dieser abgestellt werden. Eine sehr genaue Parallelität des Spalts ist hierdurch ohne besondere Maßnahmen gewährleistet, da die Auftragswalze im allgemeinen fest aufgehängt ist und die Schwenkachse der Rakel ortsfest zur Auftragswalze befestigt werden kann. Solange die Schwenkachse der Rakel parallel zur Achse der Auftragswalze ist, ist auch die Parallelität des Spalts gewährleistet. Ein weiterer Vorteil gegenüber den bisher bekannten Lösungen besteht darin, dass die Vorrichtung durch die Wegschwenkbarkeit der Rakel gegenüber einer mit linearer Anstellbewegung ausgestatteter Dosiereinrichtung kürzer baut und infolge dessen weniger Einbauraum benötigt.

Die erfindungsgemäße Auftragsvorrichtung erreicht also größtmögliche Genauigkeit beim Flüssigkeitsauftrag mit einfachen und robusten Mitteln.

Die Rakel kann mit einem Federelement an die Auftragswalze anstellbar sein, das beispielsweise ein pneumatisch betätigbarer Balgzylinder sein kann. Ein solches Federelement regelt den Anpressdruck der Rakel an die Auftragswalze in einem gewissen Bereich selbständig entsprechend der etwa sich verändernden Verhältnisse bezüglich der am Spalt anstehenden Flüssigkeitsmenge und deren Viskosität. Es entsteht mit einem Federelement also eine Art Dosierautomatik. Ein pneumatisch betätigbarer Balgzylinder hat darüber hinaus den Vorteil, dass die durch ihn hervorgerufene Anpresskraft ferngesteuert einstellbar und regelbar ist. Beispielsweise kann damit ein aktiver Regelkreis zur automatischen Dosierung hergestellt werden, indem die Schichtdicke der auf die Werkstücke aufgetragenen Flüssigkeit beispielsweise mittels Ultraschall laufend gemessen und als Stellgröße einem Proportionaldruckregelventil aufgegeben wird, welches den auf den Balgzylinder einwirkenden pneumatischen Druck steuert. Es genügt im übrigen ein einzelner Balgzylinder, um die Anstellbewegung für die Rakel zu bewirken. Eine etwa mittige Anordnung bezüglich der Rakel ist dabei vorteilhaft, um jegliche Ungenauigkeiten in der Parallelität des Spaltes, die aus einem Verwinden der Rakel resultieren könnten, sicher auszuschließen.

Besondere Vorteile ergeben sich, wenn die Rakelkante nicht in der Art einer Messerklinge geformt ist, sondern mit einer konvexen Anstellfläche versehen ist. Eine zweckmäßige Ausformung dieser konvexen Rakelkante resultiert in einer Art Übersetzung der Schwenkbewegung in eine Veränderung der Spaltbreite, d. h. eine Schwenkbewegung der Rakel um einen bestimmten Betrag ergibt eine um ein Mehrfaches verkleinerte Verengung oder Verbreiterung des Spalts an der Rakelkante.

Die Rakel kann schließlich mit einer Trägheitsmasse versehen sein, um insbesondere im Zusammenwirken mit einem Federelement eine dämpfende Wirkung durch die Massenträgheit auszuüben. Die Trägheitsmasse kann am einfachsten dadurch realisiert sein, dass die Rakel als massiver Körper ausgebildet wird. Die Trägheitsmasse kann bei entsprechender Schwerpunktanordnung gegenüber der Rakelschwenkachse als gegen die Anstellbewegung wirkendes Gewicht verwendet werden, so dass die Rakel zum Anstellen an die Auftragswalze bewegt werden muss, wohingegen die Abstellbewegung durch die Gewichtskraft der Trägheitsmasse von selbst erfolgt.

Ein Ausführungsbeispiel der Erfindung wird im folgenden anhand der beigefügten Zeichnungen näher beschrieben und erläutert. Es zeigen:
- Figur 1: eine Seitenansicht der Hauptbestandteile einer erfindungsgemäßen Auftragsvorrichtung;
- Figur 2: eine Draufsicht auf die Auftragsvorrichtung aus Figur 1;
- Figur 3: eine Ansicht aus Richtung X gemäß Figur 1;
- Figur 4: eine Ansicht aus Richtung Y gemäß Figur 1;
- Figur: 5 eine teilgeschnittene Seitenansicht entlang A-A gemäß Figur 2.

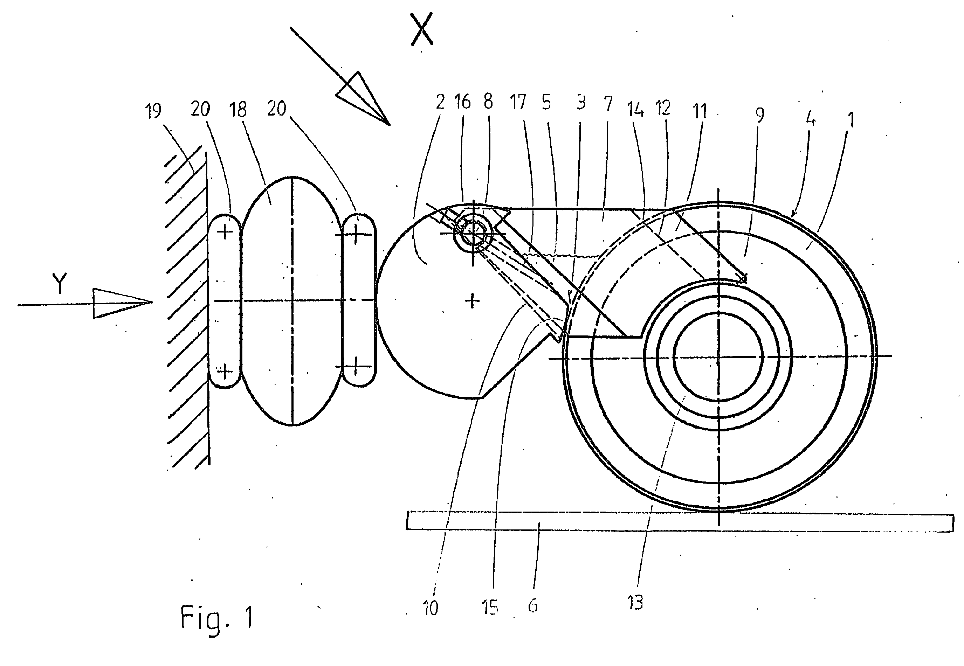

Figur 1 zeigt die Hauptbestandteile einer erfindungsgemäßen Auftragsvorrichtung in einer Seitenansicht. Erkennbar sind eine Auftragswalze 1 und eine Rakel 2, die an die Auftragswalze 1 zur Bildung eines Spalts 3 angestellt ist. Die Mantelfläche 4 der Auftragswalze 1 nimmt aus diesem Spalt 3 Flüssigkeit 5 mit und transportiert sie zu einem plattenförmigen Werkstück 6, um die Flüssigkeit 5 dort aufzutragen. Stirnseitig ist der Spalt 3 mit einer Abdichtbacke 7 abgedeckt, die an der Schwenkachse 8 der exzentrisch schwenkbar befestigten Rakel 2 aufgehängt ist und an der Stirnseite 9 der Auftragswalze 1 anliegt. Die Rakel 2 steht aus der Bildebene vorspringend über die Abdichtbacke 7 hinaus und nimmt diese in einer mit durchbrochenen Linien dargestellten Nut 10 auf. Diese Nut 10 ist derart geformt, dass die Abdichtbacke 7 darin gehaltert und geführt ist. Außerdem wird Flüssigkeit 5, die aufgrund eines etwa zu geringen Anpressdrucks der Abdichtbacke 7 gegen die Stirnseite 9 der Auftragswalze 1 entlang der Abdichtbacke 7 aus dem Spalt 3 hinausläuft, innerhalb der Nut 10 derart geführt, dass sie auf die Stirnseite 9 der Auftragswalze 1 geleitet wird. Dort wird die Flüssigkeit 5 an der Stirnseite 9 anhaftend mitgenommen und gerät nach einer Rotation um etwa 270 Winkelgrade in eine abgeschrägte Trichterfläche 11 der Abdichtbacke 7. Die Trichterfläche 11 nähert sich in Rotationsrichtung der Auftragswalze 1 der Stirnseite 9 bis zu einer Kontaktlinie 12 immer mehr an, so dass die auf der Stirnseite 9 anhaftende Flüssigkeit 5 entlang der Kontaktfläche 12, die sich mit zunehmendem Abstand von der Achse 13 der Auftragswalze 1 von einer exakt radialen Geraden zunehmend entfernt, bis zum Schnittpunkt 14 der Kontaktlinie 12 mit der Mantelfläche 4 zwangsweise transportiert wird. Am Schnittpunkt 14 gelangt die Leckage-Flüssigkeit auf die Mantelfläche 4 und wird von dieser wieder in den Spalt 3 zurückgeführt.

Zur besseren Einstellbarkeit der Spaltbreite ist die Rakelkante 15 der Rakel 2 konvex geformt, so dass die Schwenkbewegung der Rakel 2 um die Schwenkachse 8 in eine ungleich kleinere Veränderungsbewegung des Spaltabstands übersetzt wird. Die Schwenkachse 8 der Rakel 2 ist mit einem Kanal 16 zur Zuführung der Flüssigkeit 5 versehen, wobei der Kanal mit oberhalb des Spalts 3 mündenden Austrittsöffnungen 17 verbunden ist.

Auf der Rückseite der Rakel 2 ist zur Erzeugung der Anstellbewegung ein pneumatisch betätigbarer Balgzylinder 18 vorgesehen, der an einem Rahmen 19 gehaltert und von zwei Puffern 20 umgeben ist.

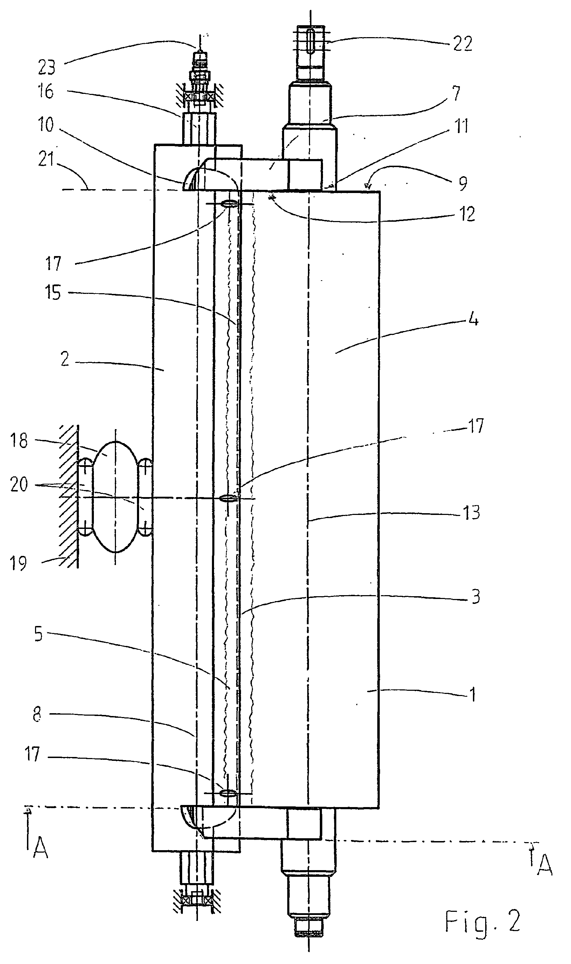

Figur 2 verdeutlicht in einer Draufsicht die Funktionsweise des dargestellten Ausführungsbeispiels weiter: Die Nut 10 und deren Formung, durch die die Leckage-Flüssigkeit zur Stirnseite 9 der Auftragswalze hin geleitet wird, ist hier deutlich zu erkennen. Ebenso wird verdeutlicht, wie an der Stirnseite 9 anhaftende Leckage-Flüssigkeit über die Trichterfläche 11 "eingefangen" und an der Kontaktlinie 12 auf die Mantelfläche 4 der Auftragswalze 1 zurückgeführt wird. Außer den anhand der Figur 1 beschriebenen Teilen, die hier mit identischen Bezugszeichen versehen sind, ist eine Stirnseitenebene 21 der Auftragswalze 1 eingezeichnet, um zu verdeutlichen, dass die Rakel 2 stirnseitig über die Auftragswalze 1 axial überstehend ausgebildet ist. Schließlich sind noch eine Antriebswelle 22 für die Auftragswalze 1 und ein Flüssigkeitszulauf 23, der sich in den Kanal 16 fortsetzt, dargestellt.

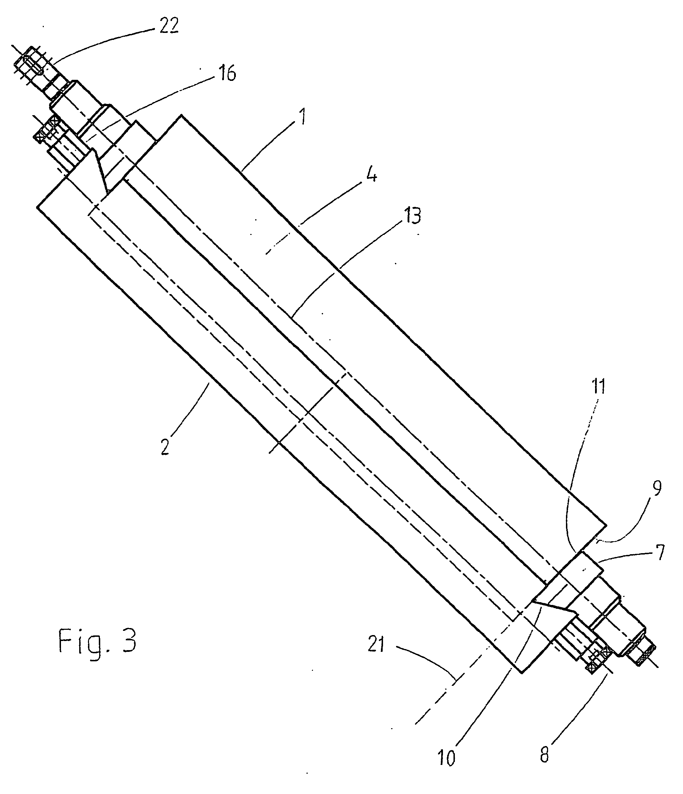

Figur 3 zeigt das Ausführungsbeispiel aus Figur 1 in einer Ansicht aus Richtung X. In dieser Ansicht wird die schwimmende Lagerung der Abdichtbacke 7 in der sich zur Stirnseitenebene 21 hin vertiefenden Nut 10 besonders deutlich. Eine Anstellbewegung der Rakel 2 führt hierdurch zu einer Bewegung der Abdichtbacke 7 zur Stirnseite 9 der Auftragswalze 1 hin. Der Balgzylinder 18 ist der besseren Verständlichkeit wegen hier weggelassen worden.

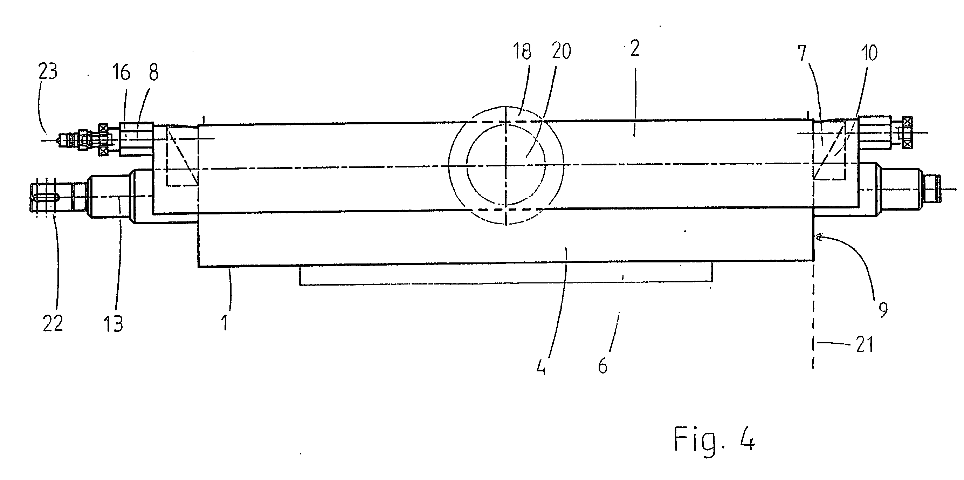

Figur 4 zeigt eine Ansicht aus Richtung Y gemäß Figur 1. Die Abdichtbacke 7 und die Nut 10 sind in dieser Darstellung eigentlich nicht sichtbar, weshalb sie mit durchbrochenen Linien angedeutet sind. Erkennbar ist hier wieder die angeschrägte Ausbildung der Nut 10 und der korrespondierende Teil der Abdichtbacke 7, der einerseits zu einer schwimmenden Lagerung der Abdichtbacke 7 führt und andererseits gewährleistet, dass Leckage-Flüssigkeit ausschließlich auf die Stirnseite 9 der Auftragswalze 1 geleitet wird, also weder abtropft noch entlang der Rakel 2 in den Bereich der plattenförmigen Werkstücke 6 oder deren Transporteinrichtung gelangt.

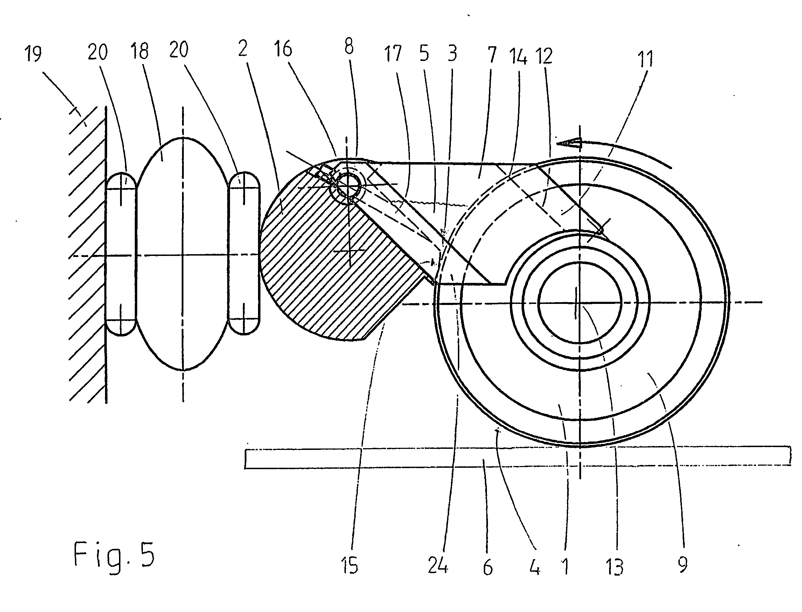

Figur 5 schließlich verdeutlicht nochmals in einer ähnlichen Darstellung wie Figur 1 die Ausbildung der Abdichtbacke 7 und der Nut 10. Korrespondierend mit dem angeschrägten Nutengrund weist die Abdichtbacke 7 eine Anschrägung 24 auf, wodurch mit der durch den Balgzylinder 18 hervorgerufenen Anstellbewegung der Rakel 2 ein gewisser, wohldefinierter Anpressdruck der Abdichtbacke 7 an die Stirnseite 9 der Auftragswalze 1 hervorgerufen wird. Im übrigen kann vollinhaltlich auf die Beschreibung der Figur 1 verwiesen werden.

### Bezugszeichenliste

- 1.: Auftragswalze
- 2.: Rakel
- 3.: Spalt
- 4.: Mantelfläche (von 1.)
- 5.: Flüssigkeit
- 6.: Werkstück
- 7.: Abdichtbacke
- 8.: Schwenkachse
- 9.: Stirnseite (von 1.)
- 10.: Nut
- 11.: Trichterfläche
- 12.: Kontaktlinie
- 13.: Achse (von 1.)
- 14.: Schnittpunkt
- 15.: Rakelkante
- 16.: Kanal
- 17.: Austrittsöffnung
- 18.: Balgzylinder
- 19.: Rahmen
- 20.: Puffer
- 21.: Stirnseitenebene
- 22.: Antriebswelle
- 23.: Flüssigkeitszulauf
- 24.: Anschrägung

## Patentansprüche

1. Auftragsvorrichtung zum Aufbringen von Flüssigkeiten, insbesondere von Lack, auf plattenförmige Werkstücke, mit einer auf den plattenförmigen Werkstücken (6) abrollenden Auftragswalze (1) und einer zur Ausbildung eines Spalts (3) für die aufzutragende Flüssigkeit (5) an die Mantelfläche (4) der Auftragswalze (1) anstellbaren Rakel (2), wobei die Flüssigkeit (5) auf der Mantelfläche (4) der Auftragswalze (1) vom Spalt (3) zum plattenförmigen Werkstück (6) transportierbar ist,
**dadurch gekennzeichnet,**
**dass** die Rakel (2) für die Anstellbewegung um eine zur Achse (13) der Auftragswalze (1) parallele Schwenkachse (8) exzentrisch schwenkbar befestigt ist.

2. Auftragsvorrichtung nach Anspruch 1,
**dadurch gekennzeichnet,**
**dass** die Rakel (2) mittels eines Federelements an die Auftragswalze (1) anstellbar ist.

3. Auftragsvorrichtung nach Anspruch 2,
**dadurch gekennzeichnet,**
**dass** das Federelement aus mindestens einem pneumatisch betätigbaren Balgzylinder (18) gebildet ist.

4. Auftragsvorrichtung nach Anspruch 3,
**dadurch gekennzeichnet,**
**dass** als Federelement ein etwa mittig auf die Rakel (2) wirkender Balgzylinder (18) vorgesehen ist.

5. Auftragsvorrichtung nach einem der Ansprüche 3 oder 4,
**dadurch gekennzeichnet,**
**dass** der Balgzylinder (18) über ein Proportionaldruckregelventil ansteuerbar ist.

6. Auftragsvorrichtung nach einem der Ansprüche 1 bis 5,
**dadurch gekennzeichnet,**
**dass** die Rakelkante (15) solcherart konvex geformt ist, dass eine Schwenkbewegung der Rakel (2) um einen bestimmten Betrag eine um ein Mehrfaches verkleinerte Verengung oder Verbreiterung des Spalts (3) an der Rakelkante (15) ergibt..

7. Auftragsvorrichtung nach einem der Ansprüche 1 bis 6,
**dadurch gekennzeichnet,**
**dass** die Rakel (2) mit einer Trägheitsmasse versehen ist.

## Claims

1. Applicator device for the application of fluids, in particular varnish, to board-like workpieces, with an applicator roller (1) which rolls on the board-like workpieces (6) and a doctor blade (2) which can be set against the surface (4) of the applicator roller (1) in order to form a gap (3) for the fluid (5) to be applied, wherein on the surface (4) of the applicator roller (1) the fluid (5) can be transported from the gap (3) to the board-like workpiece (6), **characterised in that** for the setting movement the doctor blade (2) is fixed so as to be pivotable eccentrically about a pivot axis (8) which is parallel to the axis (13) of the applicator roller (1).

2. Applicator device as claimed in Claim 1, **characterised in that** the doctor blade (2) can be set against the applicator roller (1) by means of a spring element.

3. Applicator device as claimed in Claim 2, **characterised in that** the spring element is formed by at least one bellows cylinder (18) which can be actuated pneumatically.

4. Applicator device as claimed in Claim 3, **characterised in that** a bellows cylinder (18) which acts approximately centrally on the doctor blade (2) is provided as the spring element.

5. Applicator device as claimed in any one of Claims 3 or 4, **characterised in that** the bellows cylinder (18) can be controlled by way of a proportional pressure control valve.

6. Applicator device as claimed in any one of Claims 1 to 5, **characterised in that** the edge (15) of the doctor blade is of convex shape in such a way that a pivoting movement of the doctor blade (2) by a specific amount produces a narrowing or widening, which is decreased by a multiple, of the gap (3) on the edge (15) of the doctor blade.

7. Applicator device as claimed in any one of Claims 1 to 6, **characterised in that** the doctor blade (2) is provided with an inertia mass.

## Revendications

1. Dispositif d'enduction pour appliquer des produits liquides, notamment du vernis, sur des pièces en forme de plaque, comprenant un cylindre applicateur (1) roulant sur les pièces en forme de plaque (6) et une racle (2) pouvant être placée contre la surface enveloppe (4) du cylindre applicateur (1) afin de former une fente (3) pour le liquide (5) à appliquer, le liquide (5) pouvant être transporté de la fente (3) à la pièce en forme de plaque (6) par la surface enveloppe (4) du cylindre applicateur (1), **caractérisé en ce que**, pour le mouvement de mise en place, la racle (2) est fixée de façon à pouvoir pivoter de manière excentrée autour d'un axe de pivotement (8) parallèle à l'axe (13) du cylindre applicateur (1).

2. Dispositif d'enduction selon la revendication 1, **caractérisé en ce que** la racle (2) peut être placée contre le cylindre applicateur (1) au moyen d'un élément à ressort.

3. Dispositif d'enduction selon la revendication 2, **caractérisé en ce que** l'élément à ressort est constitué d'au moins un vérin à soufflet (18) actionnable pneumatiquement.

4. Dispositif d'enduction selon la revendication 3, **caractérisé en ce qu'**est prévu en tant qu'élément à ressort un vérin à soufflet (18) agissant à peu près sur le milieu de la racle (2).

5. Dispositif d'enduction selon la revendication 3 ou 4, **caractérisé en ce que** le vérin à soufflet (18) peut être commandé par le biais d'un régulateur de pression proportionnel.

6. Dispositif d'enduction selon l'une des revendications 1 à 5, **caractérisé en ce que** l'arête (15) de la racle a une forme convexe telle qu'un pivotement de la racle (2) d'une valeur déterminée entraîne un rétrécissement ou un élargissement démultiplié de la fente (3) au niveau de l'arête (15) de la racle.

7. Dispositif d'enduction selon l'une des revendications 1 à 6, **caractérisé en ce que** la racle (2) est dotée d'une masse d'inertie.
